# EUROPEAN PATENT APPLICATION

(11) **EP 3 480 803 A1**
(43) Date of publication of application: **08.05.2019**
(21) Application number: 18204328.1
(22) Date of filing: 05.11.2018
(51) Int. Cl.: G09G 3/20, G09G 3/32, G09G 3/34, G09G 3/36, G09G 5/02

(54) **DUAL LIGHT SOURCE SYSTEM AND METHOD OF GENERATING DUAL IMAGES USING THE SAME**

(30) Priority: 07.11.2017 TW 10638459
(71) Applicant: Macroblock, Inc., Hsinchu 30072 (TW)
(72) Inventor: Huang, Ping-Kai, 30072 East Dist.,Hsinchu (TW)
(74) Representative: V.O.

(57) **Abstract**

A dual light source system (3) is adapted to be disposed in a display region (21) of a display device (100) and includes first and second light sources (31, 32) . The first light source (31) includes a plurality of first packaging units (311) each including at least one first LED element (312) and is configured to emit a plurality of visible lights having different wavelengths within a first wavelength range to generate a first image. The second light source (32) is configured to emit a plurality of invisible lights within a second wavelength range to generate a second image without interfering with the first image and includes a plurality of spaced-apart second packaging units (321) each including at least one second LED element (322). A method of generating dual images is also disclosed.

## Description

The disclosure relates to a light source system, and more particularly to a dual light source system for emitting two different lights, and a method of generating dual images using the system.

With advancement in technology, a display device has a trend have additional functions apart from displaying. For instance, the display device may be equipped with a touch panel to provide a touch function, or an infrared detector to provide photodetection function for an infrared light. In light of the trend toward increased functions and widened use of the display device, there is plenty of room for improvement in the display device having different functions for different requirements.

Therefore, an object of the disclosure is to provide a dual light source system that can alleviate at least one of the drawbacks of the prior art.

According to one aspect of the disclosure, a dual light source system is adapted to be disposed in a display region of a display device. The dual light source system includes a first light source and a second light source.

The first light source includes a plurality of first packaging units each of which includes at least one first light emitting diode (LED) element. The first light source is configured to emit a plurality of visible lights having different wavelengths within a first wavelength range to generate a first image.

The second light source is spaced apart from the first light source and includes a plurality of second packaging units each of which includes at least one second LED element that has a size no larger than that of the at least one first LED elements of each of the first packaging units. The second light source is configured to emit a plurality of invisible lights having different wavelengths within a second wavelength range to generate a second image without interfering with the first image.

According to another aspect of the disclosure, a method of generating dual images includes: driving a plurality of first LED elements disposed in a display region of a display device to emit a plurality of visible lights having different wavelengths to generate a first image that is visible; and driving a plurality of second LED elements having a size not larger than that of the first LED elements and disposed in the display region of the display device to emit a plurality of invisible lights having different wavelengths to generate a second image that is invisible.

Other features and advantages of the disclosure will become apparent in the following detailed description of the embodiments with reference to the accompanying drawings, of which:
FIG. 1 is a perspective view illustrating a first embodiment of a dual light source system according to the disclosure;
FIG. 2 is a fragmentary top view illustrating the first embodiment;
FIG. 3 is a schematic top view illustrating one configuration of one of a plurality of first packaging units of the first light source of the first embodiment;
FIG. 4 is a schematic top view illustrating another configuration of the one of the first packaging units of the first light source of the first embodiment;
FIG. 5 is a schematic top view illustrating still another form of the one of the first packaging units of the first light source of the first embodiment;
FIG. 6 is a fragmentary top view illustrating one form of a plurality of second packaging units of a second light source of the first embodiment; and
FIG. 7 is a fragmentary top view illustrating a second embodiment of the dual light source system according to the disclosure.

Before the disclosure is described in greater detail, it should be noted that where considered appropriate, reference numerals or terminal portions of reference numerals have been repeated among the figures to indicate corresponding or analogous elements, which may optionally have similar characteristics.

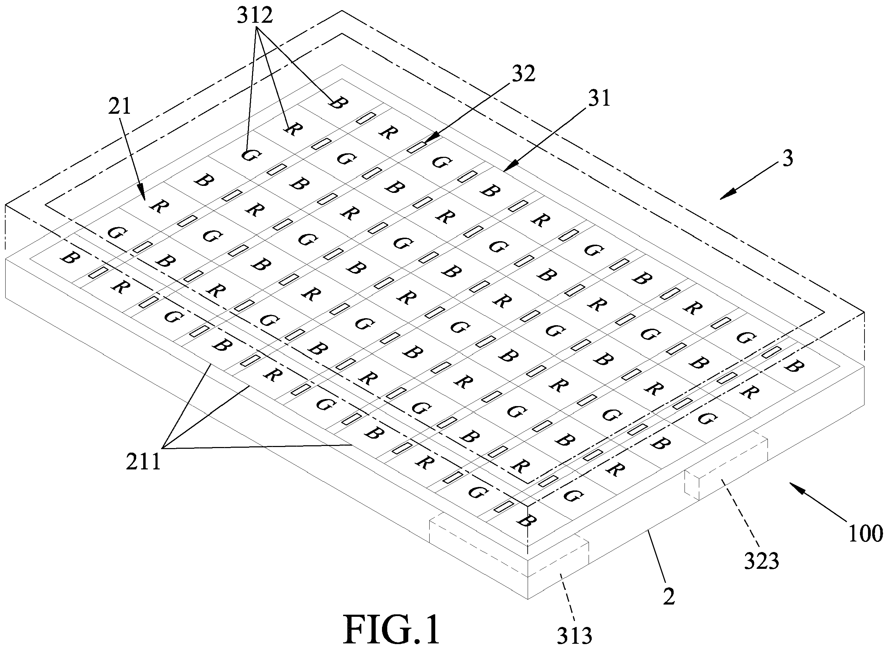

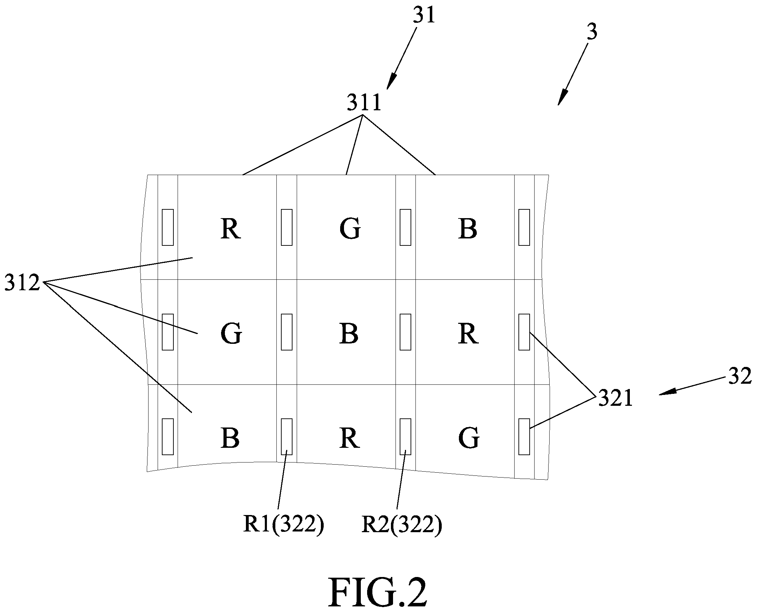

Referring to FIGS. 1 and 2, a first embodiment of a dual light source system 3 according to the disclosure is adapted to be disposed in a display region 21 of a display device 100. The dual light source system 3 includes a first light source 31 and a second light source 32. The display device 100 includes a display substrate 2 that includes the display region 21 defining a plurality of spaced-apart pixels 211 that are arranged in an array. The display device 100 may be, but is not limited to, a small-sized handheld liquid crystal display (LCD) apparatus, a household LCD apparatus, a large-sized outdoor television wall or broadcast display screen. Since detailed components of the display device 100 per se are not the essential features of the disclosure, and are well known to those skilled in the art, further details thereof are not provided herein for the sake of brevity.

The first light source 31 includes a plurality of first packaging units 311 each of which includes at least one first light emitting diode (LED) element 312, and thus the first light source 31 includes a plurality of the first LED elements 312. The first light source 31 is configured to emit a plurality of visible lights having different wavelengths within a first wavelength range to generate a first image. In FIG. 2, labels "R", "G" and "B" respectively represent different kinds of the first LED elements 312 emitting different color lights, i.e., the first LED elements 312 labeled as "R" emit red light, the first LED elements 312 labeled as "G" emit green light, and the first LED elements 312 labeled as "B" emit blue light. The first packaging units 311 are arranged in an array, and each of the first packaging units 311 is configured to be disposed in a respective one of the pixels 211.

The second light source 32 is spaced apart from the first light source 31 and includes a plurality of spaced-apart second packaging units 321. The spaced-apart second packaging units 321 are disposed in a gap that is defined by the first packaging units 311. Each of the second packaging units 321 includes at least one second LED element 322 that has a size no larger than that of the at least one first LED element 312 of each of the first packaging units 311, and thus the second light source 31 includes a plurality of the second LED elements 322. The second light source 32 is configured to emit a plurality of invisible lights having different wavelengths within a second wavelength range to generate a second image without interfering with the first image.

In FIG. 2, labels "R1" and "R2" respectively represent two different kinds of the second LED elements 322 emitting the invisible lights having two different wavelengths. More specifically, the at least one second LED element 322 of each of the second packaging units 311 is a micro-LED element. The second wavelength range may be smaller than 400 nm of an ultraviolet range, or may be greater than 780 nm of an infrared range.

The first light source 31 further includes a first driving circuit 313 that is configured to drive and control the first light source 31. The second light source 32 further includes a second driving circuit 323 that is configured to drive the second light source 32. The first and second driving circuits 313, 323 are operable to respectively drive the first and second light sources 31, 32 to generate the first image and the second image simultaneously or non-simultaneously.

In one form, the at least one micro-LED element 322 of each of the second packaging units 321 of the second light source 32 has an area smaller than 100 *µ*m × 100 *µ*m.

In one form, each of the first LED elements 312 may be a surface-mount-device (SMD) type of LEDs, a chip-on-board (COB) type of LEDs, a micro-LED, a mini-LED, etc.

In one form, the second wavelength range may be between 100 nm and 400 nm of the ultraviolet range, or between 780 nm and 1400 nm of the infrared range. In another form, the second wavelength range may be between 940 nm and 1400 nm of the infrared range.

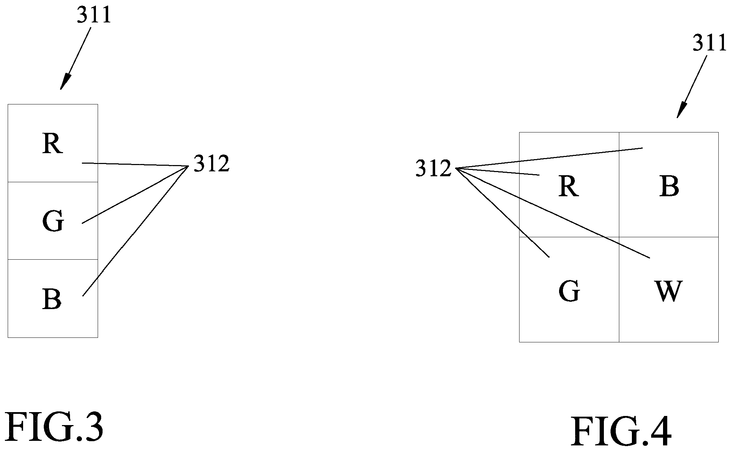

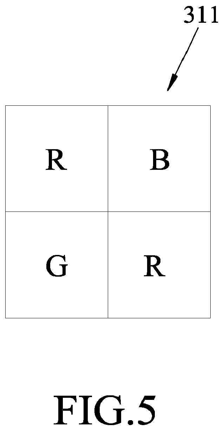

In the embodiment, the at least one first LED element 312 included in each of the first packaging units 311 has one first LED element 312, and the at least one second LED element 322 included in each of the second packaging units 321 has one second LED element 322. The second packaging units 321 are uniformly disposed in the gap defined by the first packaging units 311 which are respectively disposed in the pixels 211. In another form, each of the first packaging units 311 may include three of the first LED elements 312 that respectively emit the red light, the green light and the blue light with the labels of "R," "G" and "B" (as shown in FIG. 3). In another form, each of the first packaging units 311 may include four of the first LED elements 312 that respectively emit the red light, the green light, the blue light and a white light with the labels of "R," "G," "B," and "W" (as shown in FIG. 4). In still another form, each of the first packaging units 311 may include four of the first LED elements 312 that each emits the red light, the green light or the blue light with the labels of "R," "G" and "B." For example, as shown in FIG. 5, two of the four first LED elements 312 emit the red light, and the other two of the four first LED elements 312 emit the green and blue lights, respectively. Additionally, for the abovementioned forms of each of the first packaging units 311, an area of each of the first LED elements 312 included in each of the first packaging units 311 and an arrangement of each of the first packaging units 311 may be varied based on actual practice and the predetermined design, without being limited to the forms exemplified in FIGS. 3 to 5.

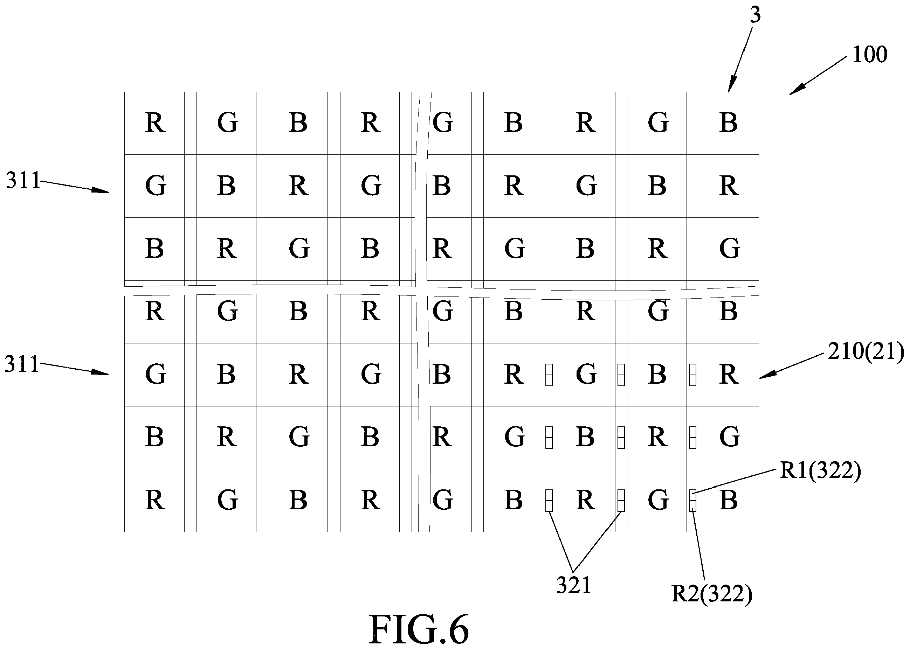

Referring back to FIG. 2, other than each of the second packaging units 32 including one of the micro-LED elements 322, in another form, each of the second packaging units 32 may instead include two of the micro-LED elements 322 that respectively emit the invisible lights having the same wavelength or different wavelengths within the second wavelength range. Referring to FIG. 6, each of the second packaging units 32 is exemplified to include two of the micro-LED elements 322 that respectively emit the invisible lights having different wavelengths with the labels of "R1" and "R2." Distribution density and arrangement of the second packaging units 32 may also vary and be determined based on the actual design and requirements. As shown in FIG. 2, the second packaging units 321 may be evenly distributed in the whole display region 21or alternatively, as shown in FIG. 6, be positioned in a corner portion 210 of the display region 21.

For a conventional display apparatus using an LED device as a light source, a spacing between any two adjacent ones of LED elements included in the LED device of the conventional display apparatus will not be larger than 200 *µ*m. Based on the design of the micro-LED elements 322 of the second light source 32 according to this disclosure, when the conventional display apparatus directly serves as the display device 100 and the first light source 31, the micro-LED elements 322 of the second light source 32 are available for being disposed in the gap among the first packaging units 311 of the first light source 31 without changing the design of the conventional display apparatus. Consequently, the second image can be generated by the invisible lights emitted from the display region 21 of the display device 100 on the premise of not interfering with the first image generated by the visible lights emitted from the first light source 31. In other words, when the dual light source system 3 of this disclosure is disposed in the display device 100, dual images with the first image and the second image generated by the dual light source system 3 can be displayed by the display device 100.

An embodiment of a method of generating dual images using the dual light source system 3 is described below.

First, the first LED elements 311 disposed in the display region 21 of the display device 100 are driven to emit the visible lights to generate the first image that is visible.

Subsequently, the second LED elements 322 having a size no larger than that of the first LED elements 312 and disposed in the display region 21 of the display device 100 are driven to emit the invisible lights to generate the second image that is invisible.

Thereafter, the second image is received and converted into a third image that is visible by an external image transceiver (not shown), and the third image is displayed separately from the first and second images on an additional display screen (not shown) that is outside the display region 21 and that is connected to the external image transceiver in a wired or wireless manner.

Since the first image is generated from the visible lights and the second image is generated from the invisible lights, the second image is not visible to a user when the user watches the display region 21 of the display device 100. The first image and the second image may be generated simultaneously or non-simultaneously. By way of the arrangement of the second packaging units 321 and the invisible property of the second image, whether the first image and the second image are generated simultaneously or not, the second image will not interfere with the first image. The second image has to be received, read and then converted by the external image transceiver to generate the third image visible to the user and separately displayed from the first image.

Referring back to FIG. 1, the display device 100 equipped with the first embodiment of the dual light source system 3 is exemplified as an outdoor display screen. The first image, such as an advertising image, may be displayed on the outdoor display screen, and the second image generated by the infrared irradiation may include an optical and machine-readable information, such as a one-dimensional barcode image or a two-dimensional barcode image (e.g. quick response (QR) code) and be invisibly and simultaneously displayed on the outdoor display screen. The external image transceiver may be a portable electronic device, such as a cell phone, that is capable of receiving and reading the second image. Since the advertising image (i.e., the first image) is not interfered with by the second image that is invisible, the user can only see the advertising image when looking at the outdoor display screen. Furthermore, when the optical and machine-readable information of the second image displayed on the outdoor display screen is scanned and received by the cell phone, the optical and machine-readable information will be converted by the cell phone into the third image that is visible and will be displayed on a display screen of the cell phone. When the optical and machine-readable information is required to be visible and to be displayed together with the advertising image, the information tends to occupy a portion of a display region for displaying the advertising image. This problem, met by the conventional display apparatus, can be avoided with displaying the optical and machine-readable information in invisible infrared irradiation. In this embodiment, the third image may be a black and white image or a gray-scaled image.

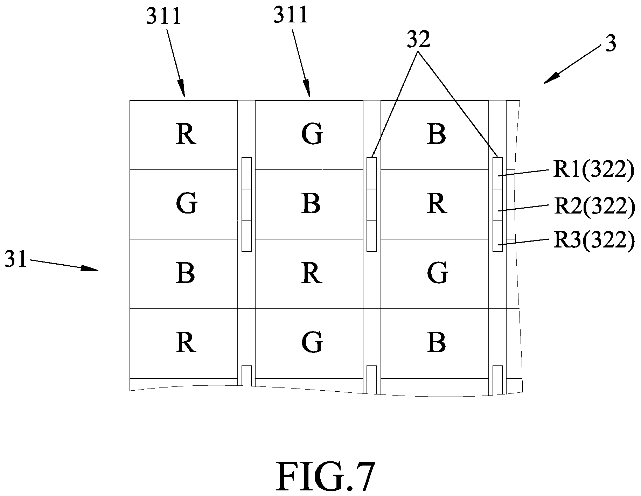

Referring to FIG. 7, a second embodiment of the dual light source system is illustrated. Each of the first packaging units 311 of the first light source 31 includes at least three of the first LED elements 312 to emit the visible lights having at least three different wavelengths within the first wavelength range. Each of the second packaging units 321 of the second light source 32 includes at least three of the second LED elements 322 to emit the invisible lights having at least three different wavelengths within the second wavelength range. In the second embodiment, each of the first packaging units 311 of the first light source 31 includes three of the first LED elements 312 respectively emitting the red light, the green light and the blue light with the labels of "R," "G" and "B." Each of the second packaging units 321 of the second light source 32 includes three of the second LED elements 322 emitting three different wavelengths with the labels of "R1," "R2" and "R3," which represent the three different wavelengths.

The second embodiment of the dual light source system 3 may be utilized in the method of generating dual images mentioned above in a manner similar to that of the first embodiment.

It should be noted that when the invisible lights emitted from the second LED elements 322 of the second light source 32 have three different wavelengths within the second wavelength range, the conversion of the second image into the third image may include respectively converting the three different wavelengths of the second image into three equivalently stimulated wavelength values of the third image through a digital signal processing system. The three equivalently stimulated wavelength values are three wavelength values of three different visible lights including the red light, the blue light and the green light. Hence, the third image is visible and is displayed on the additional display screen in full color. Since the digital signal processing system in association with the conversion of the second image into the third image is well known to those skilled in the field of image processing art, further details thereof are not provided herein for the sake of brevity. The digital signal processing system may be optionally built in or external to the external image transceiver.

When the display device 100, which is equipped with the second embodiment of the dual light source system 3 of this disclosure, is similarly exemplified as the outdoor advertising display screen, the first image may be the visible advertising image displayed on the outdoor advertising display screen and the second image may be another advertising image generated by the infrared irradiation and invisibly and simultaneously displayed on the outdoor display screen. The external image transceiver may be a broadcast video camera. Thus, the visible advertising image of the first image displayed on the outdoor display screen is not interfered with by the second image, and the third image that is visible and converted from the second image by the broadcast video camera is broadcasted and displayed on the external display screen located at a place different from that of the outdoor display screen.

For instance, when the display device 100 equipped with the second embodiment of the dual light source system 3 of this disclosure is used as an outdoor LED ribbon board display screen surrounding a sports court, the visible advertising image of the first image may be displayed on the outdoor LED ribbon board display screen, and another invisible advertising image of the second image may be simultaneously displayed on the outdoor LED ribbon board display screen. The broadcast video camera of the external transceiver receives and reads the invisible advertising image of the second image and filters out the visible advertising image of the first image so as to remove the visible advertising image and leave the invisible advertising image. Thereafter, the visible third image converted from the second image by the broadcast video camera may be broadcasted and displayed on a television at a viewer's home. Therefore, the outdoor LED ribbon board display screen can be used to solicit two different advertisements, i.e. the visible advertising image of the first image and the invisible advertising image of the second image, and an economic benefit thereof is enhanced.

To sum up, by virtue of the inclusion of the first and second light sources 31, 32, which respectively emit two different lights (i.e., the visible lights and the invisible lights) within two different wavelength ranges, in the dual light source system 3 of the disclosure, the first image and the second image can be displayed simultaneously on the same display device 100 equipped with the dual light source system 3, and the first image and the second image will not interfere with each other. Furthermore, the second image that is invisible can be converted into the third image that is visible by the external image transceiver so as to be displayed on the additional display screen different from the display region 21 for displaying the first image.

In the description above, for the purposes of explanation, numerous specific details have been set forth in order to provide a thorough understanding of the embodiments. It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the disclosure.

## Claims

1. A dual light source system (3) adapted to be disposed in a display region (21) of a display device (100), the dual light source system (3) including a first light source (31) including a plurality of first packaging units (311), each of which includes at least one first light emitting diode (LED) element (312), said dual light source system (3) **characterized by**:
said first light source (31) being configured to emit a plurality of visible lights having different wavelengths within a first wavelength range to generate a first image; and
a second light source (32) spaced apart from said first light source (31) and including a plurality of second packaging units (321) each of which includes at least one second LED element (322) that has a size no larger than that of said at least one first LED element (312) of each of said first packaging units (311), said second light source (32) being configured to emit a plurality of invisible lights having different wavelengths within a second wavelength range to generate a second image without interfering with said first image.

2. The dual light source system (3) of claim 1, **characterized in that** the display region (21) of the display device (100) defines a plurality of spaced-apart pixels (211) that are arranged in an array, said at least one second LED element (322) of each of said second packaging units (321) being a micro-LED element, said first packaging units (311) being arranged in an array, each of said first packaging units (311) being configured to be disposed in a respective one of the pixels (211), said second packaging units (321) being spaced apart from one another and being disposed in a gap defined by said first packaging units (311).

3. The dual light source system (3) of claim 2, further **characterized in that** each of said first packaging units (311) of said first light source (31) includes at least three of said first LED elements (312) to emit the visible lights having at least three different wavelengths within the first wavelength range, each of said second packaging units (321) including at least three of said micro-LED elements (322) of said second light source (32) to emit at least three different wavelengths within the second wavelength range.

4. The dual light source system (3) of claim 2, further **characterized in that** each of said micro-LED elements (322) of said second light source (32) has an area smaller than 100 µm × 100 µm.

5. The dual light source system (3) of any one of claims 1 to 4, **characterized in that** the second wavelength range is between 780 nm and 1400 nm of an infrared range.

6. The dual light source system (3) of any one of claims 1 to 4, **characterized in that** the second wavelength range is between 100 nm and 400 nm of an ultraviolet range.

7. The dual light source system (3) of any one of claims 1 to 6, **characterized in that** said first light source (31) further includes a first driving circuit (313) that is configured to drive said first light source (31), said second light source (32) further including a second driving circuit (323) that is configured to drive said second light source (32), said first and second driving circuits (313, 323) being operable to respectively drive said first and second light sources (31, 32) to generate said first image and said second image simultaneously.

8. A method of generating dual images, **characterized by**:
driving a plurality of first LED elements (311) disposed in a display region (21) of a display device (100) to emit a plurality of visible lights having different wavelengths to generate a first image that is visible; and
driving a plurality of second LED elements (322) having a size not larger than that of the first LED elements (312) and disposed in the display region (21) of the display device (100) to emit a plurality of invisible lights having different wavelengths to generate a second image that is invisible.

9. The method of claim 8, **characterized in that** each of the second LED elements (322) is a micro-LED element.

10. The method of claims 8 or claim 9, **characterized in that** the first image and the second image are generated simultaneously.

11. The method of any one of claims 8 to 10, further **characterized by** receiving the second image and converting the second image into a third image that is visible, and separately displaying the third image from the first and second images.

12. The method of claim 11, **characterized in that** the visible lights emitted from the first LED elements (312) have at least three different wavelengths, the invisible lights emitted from the second LED elements (322) having three different wavelengths, the conversion of the second image into the third image including respectively converting the three different wavelengths of the second image into three equivalently stimulated wavelength values of the third image, the visible third image being displayed in a full color form.
